(19) Europäisches Patentamt
European Patent Office
Office européen des brevets

(11) **EP 4 624 951 A1**

(12) **EUROPÄISCHE PATENTANMELDUNG**

(43) Veröffentlichungstag:
**01.10.2025 Patentblatt 2025/40**

(21) Anmeldenummer: **24166893.8**

(22) Anmeldetag: **27.03.2024**

(51) Internationale Patentklassifikation (IPC):
**G01R 31/36** (2020.01)      **G01R 31/389** (2019.01)
**H02J 7/00** (2006.01)

(52) Gemeinsame Patentklassifikation (CPC):
**G01R 31/389; H02J 7/00**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(71) Anmelder: **Siemens Aktiengesellschaft**
**80333 München (DE)**

(72) Erfinder:
• **Katzer, Felix**
**90763 Fürth (DE)**
• **Arzberger, Arno**
**96135 Stegaurach (DE)**
• **Fischer, Michael**
**91320 Ebermannstadt (DE)**
• **Radinger, Hannes**
**90459 Nürnberg (DE)**

(74) Vertreter: **Siemens Patent Attorneys**
**Postfach 22 16 34**
**80506 München (DE)**

(54) **VERFAHREN ZUM BESTIMMEN EINER ERSTEN ÜBERSPANNUNG ZWISCHEN EINER MAXIMALEN LEERLAUFSPANNUNG EINER BATTERIEZELLE UND EINER MAXIMALEN LADESPANNUNG DER BATTERIEZELLE MIT EINER MESSVORRICHTUNG; COMPUTERPROGRAMMPRODUKT; COMPUTERLESBARES SPEICHERMEDIUM SOWIE MESSVORRICHTUNG**

(57) Die Erfindung betrifft ein Verfahren zum Bestimmen zumindest einer ersten Überspannung ($\eta_{ch}$) zwischen einer maximalen Leerlaufspannung ($OCV_{max}$) einer Batteriezelle (16) und einer maximalen Ladespannung ($V_{max}$) der Batteriezelle (16) mittels einer Messvorrichtung (10), mit den Schritten Laden der Batteriezelle (16) mit einem vorgegebenen Stromwert ($I_{HPC}$) von einer minimalen Entladespannung ($V_{min}$) zu der maximalen Ladespannung ($V_{max}$) mittels eines Zyklisierers (12) der Messvorrichtung (10); Überlagern des vorgegebenen Stromwerts ($I_{HPC}$) während des Ladens mit einem Wechselstrom ($I_w$) mittels des Zyklisierers (12); Bestimmen einer die Batteriezelle (16) charakterisierenden Eigenschaft in Abhängigkeit von dem überlagerten Wechselstrom ($I_w$) mittels einer elektronischen Recheneinrichtung (14) der Messvorrichtung (10); Bestimmen der ersten Überspannung ($\eta_{ch}$) in Abhängigkeit von der bestimmten charakterisierenden Eigenschaft mittels der elektronischen Recheneinrichtung (14). Ferner betrifft die Erfindung ein Computerprogrammprodukt, ein computerlesbares Speichermedium sowie eine Messvorrichtung (10).

FIG 3

EP 4 624 951 A1

## Beschreibung

Die Erfindung betrifft ein Verfahren zum Bestimmen zumindest einer ersten Überspannung zwischen einer maximalen Leerlaufspannung einer Batteriezelle und einer maximalen Ladespannung der Batteriezelle mittels einer Messvorrichtung gemäß dem geltenden Patentanspruch 1. Ferner betrifft die Erfindung ein entsprechendes Computerprogrammprodukt, ein entsprechendes computerlesbares Speichermedium sowie eine entsprechende Messvorrichtung.

Batteriezellen lassen sich durch verschiedene Kenngrößen charakterisieren, die je nach Zelltyp, Betriebsbedingungen und Produktionsqualität jedoch deutliche Unterschiede aufweisen können. Zwei in der Praxis wichtige Kenngrößen sind dabei die Lebensdauer und die Selbstentladungsrate. Die Lebensdauer ergibt sich aus der Zellalterung, die im Wesentlichen den irreversiblen Verlust der nutzbaren Kapazität in Betriebszyklen und Zeit beschreibt. Die Selbstentladungsrate beschreibt den reversiblen Kapazitätsverlust über die Zeit. Beiden Kenngrößen ist gemein, dass sie im Normalfall nur über größere Zeitskalen zu messbaren Änderungen führen. Für praktische Untersuchungen und Bewertungen von Batteriezellen ist es hingegen wichtig, während möglichst kurzer Zeit Tests durchzuführen, welche relevante Aussagen über Kenngrößen liefern können. Aktuell werden die Zellen allerdings etwa eine Woche gelagert, um Selbstentladung anhand von Messungen vor beziehungsweise nach der Lagerung zu bestimmen. Es werden daher Methoden zur Bestimmung der Selbstentladung innerhalb von wenigen Stunden benötigt, welche dieses Vorgehen ersetzen können.

Um die Testdauer von Lebensdauer- und Selbstentladungsmessungen zu verkürzen, wird deswegen einerseits auf beschleunigte Tests zurückgegriffen, die bei höheren Temperaturen und gegebenenfalls höheren Stromstärken durchgeführt werden und so eine beschleunigte Alterung von Selbstentladungen der Zellen provozieren. Allerdings stellen diese Testbedingungen dann nicht das Verhalten der Zellen unter relevanten Betriebsbedingungen dar, welches durch diese Tests beschrieben werden soll. Darüber hinaus verschlechtert sich die Energieeffizienz der Zellproduktion durch die Verwendung von hohen Temperaturen und Strömen. Aufgrund dessen, sowie der Veränderung der Batteriezellen durch diese Tests, eignet sich dieses Verfahren daher nur als stichprobenartiger Test in der Produktion und nicht zur Prüfung aller produzierten Zellen.

Andere Verfahren fokussieren sich daher auf eine erhöhte Genauigkeit in den Testmessungen, um kleine Änderungen bereits auf kurzen Zeitskalen zu quantifizieren. Im Speziellen kann hier die High Precision Coulometry (HPC)-Methode genannt werden, bei der aus der Batteriezelle entnommene beziehungsweise in ihr gespeicherte Ladungsmengen sehr genau gemessen werden. Das HPC-Verfahren misst insbesondere die genauen Ladungsmengen während der einzelnen Lade- und Entladeschritte. Damit lassen sich sowohl die Coulombic Effeciency (CE) als auch kleine Kapazitätsverluste innerhalb von wenigen Zyklen genau bestimmen. Hieraus wiederum ergeben sich beispielsweise Aussagen dann über die Selbstentladungsrate und die Lebensdauer einer Batteriezelle.

Aufgabe der vorliegenden Erfindung ist es, ein Verfahren, ein Computerprogrammprodukt, ein computerlesbares Speichermedium sowie eine Messvorrichtung zu schaffen, mittels welchen die Bestimmung einer Überspannung einer Batteriezelle verbessert wird.

Diese Aufgabe wird durch ein Verfahren, ein Computerprogrammprodukt, ein computerlesbares Speichermedium sowie eine Messvorrichtung gemäß den unabhängigen Patentansprüchen gelöst. Vorteilhafte Ausgestaltungsformen sind in den Unteransprüchen angegeben.

Ein Aspekt der Erfindung betrifft ein Verfahren zum Bestimmen zumindest einer ersten Überspannung zwischen einer maximalen Leerlaufspannung einer Batteriezelle und einer maximalen Ladespannung der Batteriezelle mittels einer Messvorrichtung. Die Batteriezelle wird mit einem vorgegebenen Stromwert von einer minimalen Ladespannung zu der maximalen Ladespannung mittels eines Zyklisierers der Messvorrichtung geladen. Es erfolgt das Überlagern des vorgegebenen Stromwerts während des Ladens mit einem Wechselstrom mittels des Zyklisierers und es wird eine die Batteriezelle charakterisierende Eigenschaft in Abhängigkeit von dem überlagerten Wechselstrom mittels einer elektronischen Recheneinrichtung der Messvorrichtung bestimmt. Es erfolgt das Bestimmen der ersten Überspannung in Abhängigkeit von der bestimmten charakterisierenden Eigenschaft mittels der elektronischen Recheneinrichtung.

Insbesondere ermöglicht somit die Erfindung eine präzise Qualitätsbestimmung der Batteriezelle, so dass die Überspannung am Ende des Ladezyklus möglichst genau bestimmt werden kann, um den gewünschten Betriebsbereich einzuhalten.

Beim Stand der Technik führen Zellvariationen und Messfehler der Temperatur zu einer fehlerhaften Einschätzung dieser Überspannung. Mit Hilfe des vorgeschlagenen Verfahrens können zum einen zellindividuelle Widerstände berücksichtigt werden, und zum anderen werden Temperatureffekte ebenfalls mitberücksichtigt. Somit kann online auf geringste Änderungen der Betriebsbedingungen reagiert werden und die Präzision des Qualitätsverfahrens somit entscheidend erhöht werden. Insbesondere erübrigt sich somit eine vorgelagerte Erstellung eines LUT (englisch: "look-up table"), insbesondere bezüglich von Ladewiderständen und Entladewiderständen, insbesondere temperaturspezifisch, und spart somit entsprechend viel Zeit ein.

Insbesondere ist das Verfahren vorteilhaft, da die relevante Messung der Stromstärke dazu führt, dass es zu kinetischen Effekten innerhalb der Batteriezelle kommt, wodurch die an der Batteriezelle messbare Spannung nicht mehr der tatsächlichen Ruhespannung (Leerlaufspannung) entspricht. Konkret werden dabei Messungen von elektrischen Parametern in Abhängigkeit von der Temperatur durchgeführt, um beispielsweise einen Innenwiderstand der Batteriezelle unter den aktuellen Testbedingungen zu ermitteln. Aus diesem Innenwiderstand ergibt sich dann die zu erwartende Überspannung η, also der Unterschied zwischen gemessener Spannung und der Leerlaufspannung.

$$V = OCV + η = OCV + R \bullet I$$

Entsprechend kann nun zu einem um die Überspannung höher beziehungsweise im späteren Verfahren auch tiefer liegenden Spannungswert geladen beziehungsweise entladen werden, sodass die Leerlaufspannungen beziehungsweise Ruhespannungen weiterhin den entsprechenden Zielwert erreichen.

Die Ruhespannung ist jedoch nicht explizit messbar, und die Überspannung ist von vielen Faktoren abhängig. Wesentlichen Einfluss hat dabei die Temperatur. Außerdem gibt es eine starke Variation des Innenwiderstands zwischen den Batteriezellen, sogar, wenn diese aus derselben Charge entspringen.

Das technische Problem ist somit, dass die Methode eine sehr präzise Ansteuerung der gewünschten Leerlaufspannung benötigt. Hierfür müssen Überspannungen möglichst korrekt berücksichtigt werden. Diese hängen jedoch von vielen Faktoren ab, die nur bedingt messbar sind.

Somit ist vorliegend insbesondere vorgeschlagen, dass die Zyklisierung der Batteriezelle im Rahmen des Verfahrens mit einem periodischen, sinusförmigen Strom überlagert wird. Ziel ist es dabei, die Impedanz bei gegebener Frequenz zu bestimmen:

$$Z(\omega) = \frac{\widehat{U} * \sin(\omega t + \Phi)}{\widehat{I} * \sin(\omega t)}$$

Mit w als die Winkelgeschwindigkeit, diese ist proportional zur Frequenz über w=2*pi*f; Bei einer Elektrochemischen Impedanzspektroskopie wird die Impedanz bei verschiedenen Frequenzpunkten bestimmt, also Z(f) oder Z(w). Φ entspricht dem Phasenunterschied zwischen Strom und Spannungssignal. Die imaginären Anteile der Impedanz (hier hauptsächlich Kapazitäten) führen zu diesem Φ. $\widehat{U}$ und $\widehat{I}$ sind die Maximalwerte des periodischen Strom- und Spannungssignals.

Es sollen dabei insbesondere mehrere Frequenzen gemessen werden, um eine elektrochemische Impedanzspektroskopie (EIS) aufzunehmen.

Gemäß einer vorteilhaften Ausgestaltungsform kann als charakterisierende Eigenschaft eine Temperatur in der Batteriezelle bestimmt werden. Insbesondere, da sich die entsprechenden Eigenschaften der Batteriezelle durch eine Temperaturänderung verändern, können durch die entsprechend bestimmte Temperatur diese Effekte wiederum berücksichtigt werden. Somit kann zuverlässig beispielsweise ein Qualitätsprüfverfahren für die Batteriezelle realisiert werden.

Dabei hat es sich weiterhin als vorteilhaft erwiesen, wenn der Stromwert mit einem Wechselstrom mit einer Frequenz von mehr als 1 kHz überlagert wird. Insbesondere bei der Temperaturmessung hat es sich erwiesen, dass die Impedanz bei hohen Frequenzen, insbesondere höher 1 kHz, eine gute Abschätzung der Temperatur erlaubt. Somit können die Temperatureffekte zuverlässig mitberücksichtigt werden.

Es ist weiterhin vorteilhaft, wenn als charakterisierende Eigenschaft ein Gleichstromwiderstand in der Batteriezelle bestimmt wird. Insbesondere können auf Basis von möglichst vielen niedrigen Frequenzen das Diffusionsverhalten und somit die DC-Widerstände, insbesondere während des Ladevorgangs, aber auch während des Entladevorgangs, abgeschätzt werden. Dadurch erübrigt sich die vorgelagerte Erstellung eines LUT, wodurch insbesondere Zeit eingespart werden kann.

Dabei hat es sich weiterhin als vorteilhaft erwiesen, wenn der Stromwert mit einem Wechselstrom mit einer Frequenz von weniger als 1 kHz überlagert wird. Insbesondere weist beispielsweise die Frequenz weniger als 100 Hz auf.

Weiterhin vorteilhaft ist, wenn mittels des überlagerten Wechselstroms eine Impedanzanalyse der Batteriezelle durchgeführt wird. Insbesondere wird eine elektrochemische Impedanzspektroskopie durchgeführt. Somit kann zuverlässig die Überspannung ermittelt werden.

Es hat sich weiterhin als vorteilhaft erwiesen, wenn mittels des überlagerten Wechselstroms eine zweite Überspannung der Batteriezelle zwischen einer minimalen Leerlaufspannung und einer minimalen Ladespannung durchgeführt wird. Insbesondere kann somit auch beim Entladen der entsprechende Wechselstrom überlagert werden, sodass auch eine Überspannung beim Entladen, insbesondere zwischen der minimalen Leerlaufspannung und der minimalen Ladespannung, entsprechend bestimmt werden kann. Somit kann beispielsweise zuverlässig ein entsprechendes Qualitätsprüfungsverfahren zwischen der maximalen Ladespannung und der minimalen Ladespannung unter Berücksichtigung der Überspannungen realisiert werden.

Ebenfalls vorteilhaft ist, wenn die Überlagerung des Wechselstroms im Wesentlichen an einem Ende des Ladevorgangs durchgeführt wird. Insbesondere ist somit ein Zeitfenster vor dem Ende des Ladevorgangs vorgesehen, bei welchem eine Wechselstromüberlagerung durchgeführt wird. Mit anderen Worten kann der Ladevorgang ohne Überspannung des Wechselstroms beginnen und dann während des Ladens ein entsprechendes Zeitfenster eingeräumt werden, bei welchem das Wechselstromsignal mitüberlagert wird. Dies hat insbesondere den Vorteil, dass während des Ladens die Batteriezelle bereits eine Temperaturänderung erfährt und am Ende des Ladeprozesses somit entsprechende Temperaturen besser berücksichtigt werden können.

Weiterhin vorteilhaft ist, wenn die Überlagerung des Wechselstroms vor einem Ende des Lade- bzw. Entladevorgangs abgeschlossen wird. Insbesondere kann somit sichergestellt werden, dass die periodische Anregung der EIS ladungsneutral ist, damit das Qualitätsverfahren entsprechend nicht verfälscht wird. Um mögliche Fehlereinflüsse zu minimieren, wird die EIS in einem möglichst kleinen Zeitfenster durchgeführt. Das Zeitfenster sollte dabei möglichst am Ende eines Zyklus liegen, damit die anliegende Überspannung möglichst nahe am SOCend bestimmt werden kann. Das Zeitfenster darf jedoch nicht bis zum Ende des Zyklus reichen, um ausschließen zu können, dass über den avisierten SOCend hinaus geladen wird, weil die EIS-Messung abgeschlossen werden muss.

Weiterhin vorteilhaft ist, wenn zumindest ein erster Wechselstrom mit einer ersten Frequenz und ein zweiter Wechselstrom mit einer zur ersten Frequenz unterschiedlichen zweiten Frequenz auf den Stromwert überlagert werden. Insbesondere kann eine Vielzahl von unterschiedlichen Frequenzen auf den vorgegebenen Stromwert überlagert werden. Insbesondere kann somit eine elektrochemische Impedanzspektroskopie bereitgestellt werden. Somit kann zuverlässig die Überspannung bestimmt werden.

In einer weiteren vorteilhaften Ausgestaltungsform ist vorgesehen, dass eine zugeführte Ladungsmenge während des Ladens mittels der elektronischen Recheneinrichtung der Messvorrichtung bestimmt wird und die Batteriezelle mit dem vorgegebenen Stromwert von der maximalen Ladespannung zu einer minimalen Ladespannung mittels des Zyklisierers entladen wird und eine entnommene Ladungsmenge während des Entladens bestimmt wird und ein Alterungszustand der Batteriezelle und/oder eine Selbstentladung der Batteriezelle in Abhängigkeit von der bestimmten zugeführten Ladungsmenge und der bestimmten entnommenen Ladungsmenge bestimmt wird. Somit kann das vorgestellte Verfahren insbesondere zuverlässig für die Qualitätsbestimmung von Batteriezellen genutzt werden.

Weiterhin vorteilhaft ist, wenn das Verfahren während eines Hochpräzisionscoulometrie-Verfahrens durchgeführt wird. Dabei handelt es sich insbesondere um das bereits erwähnte High Precision Coulometry (HPC)-Verfahren. Das HPC-Verfahren misst die genauen Ladungsmengen während der einzelnen Lade- und Entladeschritte. Insbesondere verfolgt dabei das HPC-Verfahren entsprechende Testzyklen, bei denen die Batteriezelle zwischen zwei definierten Zuständen, insbesondere beschrieben durch eine maximale Leerlaufspannung und die minimale Leerlaufspannung, mit einer definierten Stromstärke zyklisiert wird. Die Dauer der einzelnen Lade- und Entladeschritte tcharge und tdischarge hängen dabei von den Eigenschaften der getesteten Batteriezelle ab. Auf Basis des HPC-Verfahrens kann somit hochpräzise die Coulombic Effeciency entsprechend bestimmt werden und auf Basis dessen wiederum zuverlässig die charakterisierende Eingabe der Batteriezelle bestimmt werden. Dabei betrifft das vorgestellte Verfahren zumindest in Teilen ein computerimplementiertes Verfahren. Daher betrifft ein weiterer Aspekt der Erfindung ein Computerprogrammprodukt mit Programmcodemitteln, welche eine elektronische Recheneinrichtung dazu veranlassen, wenn die Programmcodemittel von der elektronischen Recheneinrichtung abgearbeitet werden, ein Verfahren nach dem vorhergehenden Aspekt durchzuführen.

Ebenfalls betrifft die Erfindung auch ein computerlesbares Speichermedium mit einem Computerprogrammprodukt nach dem vorhergehenden Aspekt.

Weiterhin betrifft die Erfindung auch eine Messvorrichtung zum Bestimmen zumindest einer ersten Überspannung zwischen einer maximalen Leerlaufspannung einer Batteriezelle und einer maximalen Ladespannung der Batteriezelle, mit zumindest einem Zyklisierer und einer elektronischen Recheneinrichtung, wobei die Messvorrichtung zum Durchführen eines Verfahrens nach dem vorhergehenden Aspekt ausgebildet ist. Insbesondere wird das Verfahren mittels der Messvorrichtung durchgeführt.

Vorteilhafte Ausgestaltungsformen des Verfahrens sind als vorteilhafte Ausgestaltungsformen des Computerprogrammprodukts, des computerlesbaren Speichermediums sowie der Messvorrichtung vorzusehen. Die Messvorrichtung weist hierzu gegenständliche Merkmale auf, um entsprechende Verfahrensschritte durchführen zu können.

Unter einer Recheneinheit/elektronische Recheneinrichtung kann insbesondere ein Datenverarbeitungsgerät verstanden werden, das einen Verarbeitungsschaltkreis enthält. Die Recheneinheit kann also insbesondere Daten zur Durchführung von Rechenoperationen verarbeiten. Darunter fallen gegebenenfalls auch Operationen, um indizierte Zugriffe auf eine Datenstruktur, beispielsweise eine Umsetzungstabelle (LUT) durchzuführen.

Die Recheneinheit kann insbesondere einen oder mehrere Computer, einen oder mehrere Mikrocontroller und/oder einen oder mehrere integrierte Schaltkreise enthalten, beispielsweise eine oder mehrere anwendungsspezifische integrierte Schaltungen, ASIC (englisch: "application-specific integrated circuit"), eines oder mehrere feldprogrammierbare Gate-Arrays, FPGA, und/oder eines oder mehrere EinchipsystemeDie Recheneinheit kann auch einen oder mehrere Prozessoren, beispielsweise einen oder mehrere Mikroprozessoren, eine oder mehrere zentrale Prozessoreinheiten, CPU (englisch: "central processing unit"), eine oder mehrere Grafikprozessoreinheiten, GPU (englisch: "graphics processing unit") und/oder einen oder mehrere Signalprozessoren, insbesondere einen oder mehrere Digitalsignalprozessoren, DSP, enthalten. Die Recheneinheit kann auch einen physischen oder einen virtuellen Verbund von Computern oder sonstigen der genannten Einheiten beinhalten.

In verschiedenen Ausführungsbeispielen beinhaltet die Recheneinheit eine oder mehrere Hardware- und/oder Softwareschnittstellen und/oder eine oder mehrere Speichereinheiten.

Eine Speichereinheit kann als flüchtiger Datenspeicher, beispielsweise als dynamischer Speicher mit wahlfreiem Zugriff, DRAM (englisch: "dynamic random access memory") oder statischer Speicher mit wahlfreiem Zugriff, SRAM (englisch: "static random access memory"), oder als nicht-flüchtiger Datenspeicher, beispielsweise als Festwertspeicher, ROM (englisch: "read-only memory"), als programmierbarer Festwertspeicher, PROM (englisch: "programmable read-only memory"), als löschbarer programmierbarer Festwertspeicher, EPROM (englisch: "erasable programmable read-only memory"), als elektrisch löschbarer programmierbarer Festwertspeicher, EEPROM (englisch: "electrically erasable programmable read-only memory"), als Flash-Speicher oder Flash-EEPROM, als ferroelektrischer Speicher mit wahlfreiem Zugriff, FRAM (englisch: "ferroelectric random access memory"), als magnetoresistiver Speicher mit wahlfreiem Zugriff, MRAM (englisch: "magnetoresistive random access memory") oder als Phasenänderungsspeicher mit wahlfreiem Zugriff, PCRAM (englisch: "phase-change random access memory"), ausgestaltet sein.

Für Anwendungsfälle oder Anwendungssituationen, die sich bei einem erfindungsgemäßen Verfahren ergeben können und die hierin nicht explizit beschrieben sind, kann vorgesehen sein, dass gemäß dem Verfahren eine Fehlermeldung und/oder eine Aufforderung zur Eingabe einer Nutzerrückmeldung ausgegeben und/oder eine Standardeinstellung und/oder ein vorbestimmter Initialzustand eingestellt wird.

Unabhängig vom grammatikalischen Geschlecht eines bestimmten Begriffes sind Personen mit männlicher, weiblicher oder anderer Geschlechteridentität mit umfasst.

Weitere Merkmale und Merkmalskombinationen der Erfindung ergeben sich aus den Figuren und deren Beschreibung sowie aus den Ansprüchen. Insbesondere müssen weitere Ausführungsformen der Erfindung nicht unbedingt alle Merkmale eines der Ansprüche enthalten. Weitere Ausführungsformen der Erfindungen können Merkmale oder Merkmalskombinationen aufweisen, die nicht in den Ansprüchen genannt sind.

Dabei zeigen:

Fig. 1 ein schematisches Blockschaltbild gemäß einer Ausführungsform einer Messvorrichtung mit einer Ausführungsform einer Batteriezelle;

Fig. 2 ein schematisches Zeit-Spannungsdiagramm für einen Zyklus einer Batteriezelle; und

Fig. 3 ein weiteres schematisches Zeit-Spannungsdiagramm für eine Ausführungsform des Verfahrens.

Die Erfindung wird im Folgenden anhand konkreter Ausführungsbeispiele und zugehöriger schematischer Zeichnungen näher erläutert. In den Figuren können gleiche oder funktionsgleiche Elemente mit denselben Bezugszeichen versehen sein. Die Beschreibung gleicher oder funktionsgleicher Elemente wird gegebenenfalls nicht notwendigerweise bezüglich verschiedener Figuren wiederholt.

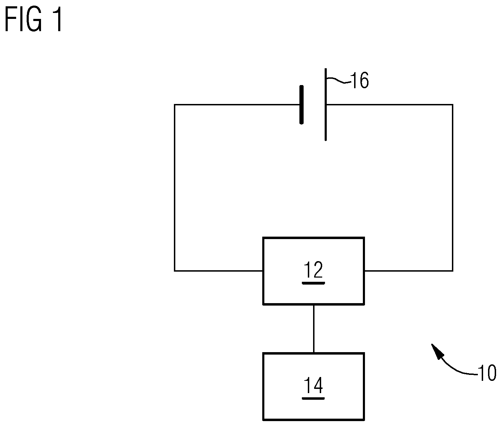

Fig. 1 zeigt ein schematisches Blockschaltbild gemäß einer Ausführungsform einer Messvorrichtung 10. Die Messvorrichtung 10 weist im vorliegenden Ausführungsbeispiel zumindest einen Zyklisierer 12 sowie eine elektronische Recheneinrichtung 14 auf. Die Messvorrichtung 10 ist zum Bestimmen einer Eigenschaft einer Batteriezelle 16 ausgebildet. Beispielsweise können als Eigenschaft ein Alterungszustand und/oder ein Selbstentladeverhalten der Batteriezelle 16 bestimmt werden.

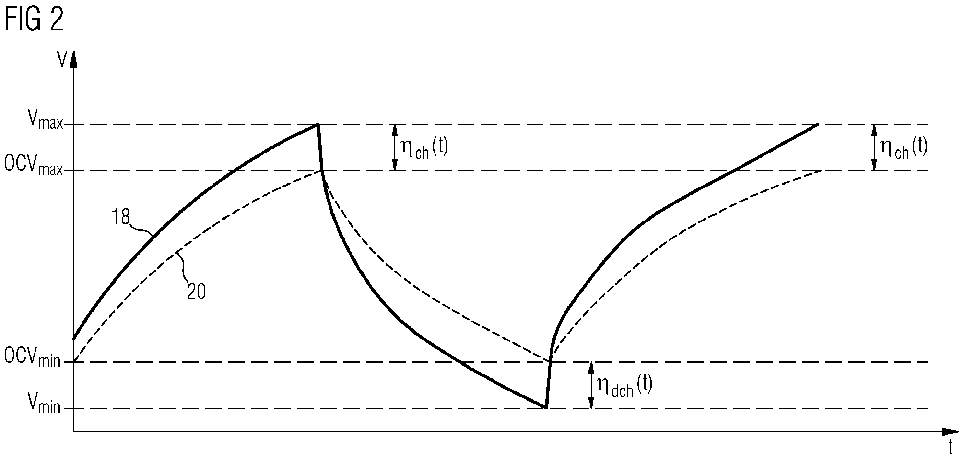

Fig. 2 zeigt ein schematisches Zeit(t)-Spannungs(V)-Diagramm. Insbesondere ist in der Fig. 2 eine maximale Leerlaufspannung $OCV_{max}$ sowie eine maximale Ladespannung $V_{max}$ gezeigt. Ferner ist eine minimale Leerlaufspannung $OCV_{min}$ sowie eine minimale Entladespannung $V_{min}$ gezeigt. Des Weiteren zeigt die Fig. 2, dass beispielsweise zwischen der maximalen Leerlaufspannung $OCV_{max}$ und der maximalen Ladespannung $V_{max}$ eine erste Überspannung $\eta_{ch}$ (t) zu verzeichnen ist. Ferner ist zwischen der minimalen Leerlaufspannung $OCV_{min}$ und der minimalen Entladespannung $V_{min}$ eine zweite Überspannung $\eta_{dch}$ (t) zu verzeichnen.

Insbesondere zeigt somit die Fig. 2 den Vergleich von einer gemessenen Spannung, den Verlauf der entsprechenden Lade- und Entladespannungen $V_{min}$ und $V_{max}$, was insbesondere durch eine erste Kurve 18 dargestellt ist, und den Verlauf der entsprechenden Leerlaufspannung $OCV_{min}$ und $OCV_{max}$, was durch eine zweite Kurve 20 dargestellt ist. An den jeweiligen Grenzen des Testzyklus wird bis zu einer um die aktuelle Überspannung $\eta_{ch}$, $\eta_{dch}$ erweiterte Spannungsgrenze gemessen, damit die Ruhespannungen $OCV_{min}$, $OCV_{max}$ die gewünschten Grenzen erreichen. Diese wiederum definieren den sogenannten Stateof-Charge-Bereich (SOC). Die Überspannung $\eta_{ch}$, $\eta_{dch}$ ist dabei abhängig von der Temperatur.

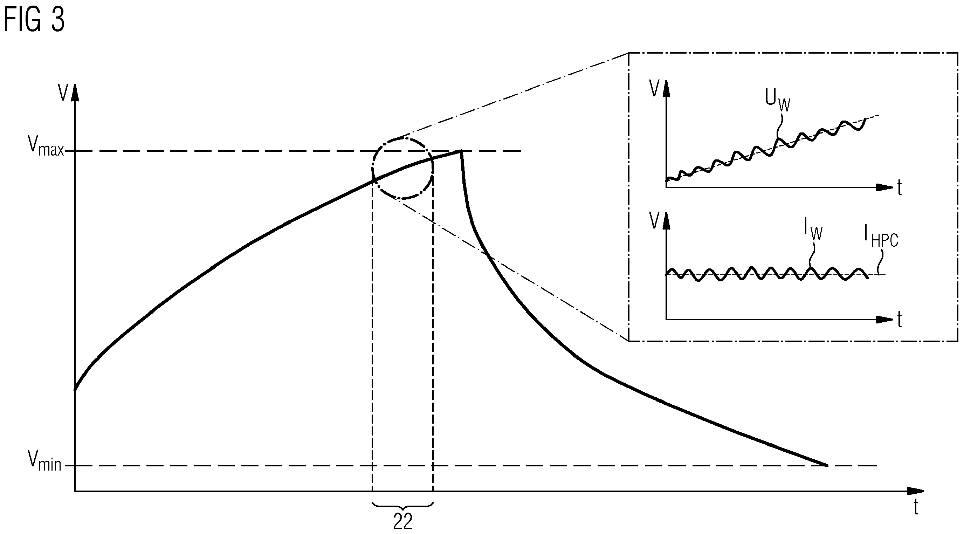

Fig. 3 zeigt ein weiteres Zeit(t)-Spannungs(V)-Diagramm. Insbesondere zeigt die Fig. 3 eine Ausführungsform eines Verfahrens zum Bestimmen der Überspannung $\eta_{ch}$, $\eta_{dch}$. Im vorliegenden Ausführungsbeispiel ist insbesondere gezeigt, wie die erste Überspannung $\eta_{ch}$ während eines Ladevorgangs bestimmt wird. Dabei ist vorliegend insbesondere vorgesehen, dass die Batteriezelle 12 mit einem vorgegebenen Stromwert $I_{HPC}$ von der minimalen Ladespannung $V_{min}$ zu der maximalen Ladespannung $V_{max}$ mittels des Zyklisierers 12 der Messvorrichtung 10 geladen. Es erfolgt dann das Überlagern des vorgegebenen Stromwerts $I_{HPC}$ während des Ladens mit einem Wechselstrom $I_W$

mittels des Zyklisierers 12. Es erfolgt dann das Bestimmen einer die Batteriezelle 12 charakterisierenden Eigenschaft in Abhängigkeit von dem überlagerten Wechselstrom Iw mittels der elektronischen Recheneinrichtung 14 und das Bestimmen der ersten Überspannung $\eta_{ch}$ in Abhängigkeit von der bestimmten charakterisierenden Eigenschaft mittels der elektronischen Recheneinrichtung 14. Dabei kann als charakterisierende Eigenschaft insbesondere eine Temperatur in der Batteriezelle 12 bestimmt werden. Insbesondere kann dabei der Stromwert $I_{HPC}$ mit einem Wechselstrom $I_W$ mit einer Frequenz von mehr als 1 kHz überlagert werden. Ferner kann als charakterisierende Eigenschaft auch ein Gleichstromwiderstand in der Batteriezelle 12 bestimmt werden. Dabei kann der Stromwert $I_{HPC}$ mit einem Wechselstrom $I_W$ mit einer Frequenz von weniger als 1 kHz überlagert werden.

Ferner ist insbesondere vorgesehen, dass mittels des überlagerten Wechselstroms $I_W$ eine Impedanzanalyse der Batteriezelle 12 durchgeführt wird.

Ferner ist, wie bereits erwähnt, vorgesehen, dass mittels des überlagerten Wechselstroms $I_W$ eine zweite Überspannung $\eta_{dch}$ der Batteriezelle 12 zwischen der minimalen Leerlaufspannung $OCV_{min}$ und der minimalen Ladespannung $V_{min}$ durchgeführt wird.

Die Fig. 3 zeigt ferner, dass die Überlagerung des Wechselstroms Iw im Wesentlichen an einem Ende des Ladevorgangs durchgeführt wird. Vorliegend ist insbesondere dies durch ein Zeitfenster 22 dargestellt. Dabei ist ferner vorgesehen, dass die Überlagerung des Wechselstroms Iw vor einem Ende des Ladevorgangs abgeschlossen ist.

Weiter ist insbesondere vorgesehen, dass zumindest ein erster Wechselstrom $I_W$ mit einer ersten Frequenz und ein zweiter Wechselstrom mit einer zur ersten Frequenz unterschiedlichen zweiten Frequenz auf den Stromwert $I_{HPC}$ überlagert werden.

Ferner kann vorgesehen sein, dass eine zugeführte Ladungsmenge während des Ladens bestimmt wird und die Batteriezelle 16 mit dem vorgegebenen Stromwert $I_{HPC}$ von der maximalen Ladespannung $V_{max}$ zu einer minimalen Ladespannung $V_{min}$ mittels des Zyklisierers 12 entladen wird und eine entnommene Ladungsmenge während des Entladens bestimmt wird und ein Alterungszustand der Batteriezelle 16 und/oder eine Selbstentladung der Batteriezelle 16 in Abhängigkeit von der bestimmten zugeführten Ladungsmenge und der bestimmten entnommenen Ladungsmenge bestimmt wird.

Dabei sieht die Erfindung weiter vor, dass das Verfahren insbesondere während eines Hochpräzisionscoulometrie-Verfahrens durchgeführt wird.

Insbesondere ist somit vorgesehen, dass die Zyklisierung der Batteriezelle 16 im Rahmen einer HPC-Messung mit einem periodischen, sinusförmigen Wechselstrom $I_W$ überlagert wird. Ziel ist es hierbei, die Impedanz bei gegebener Frequenz zu bestimmen. Dabei kann insbesondere die Formel

$$Z(\omega) = \frac{\hat{U} * \sin(\omega t + \Phi)}{\hat{I} * \sin(\omega t)}$$

genutzt werden. Dabei können insbesondere mehrere Frequenzen gemessen werden, um eine elektrochemische Impedanzspektroskopie (EIS) aufzunehmen. Somit können einerseits Temperatureffekte berücksichtigt und andererseits die zellindividuellen DC-Widerstände $R_{ch}$ (ohmscher Widerstand beim Laden) und $R_{dch}$ (ohmscher Widerstand beim Entladen) abgeschätzt werden. Die Impedanz bei hohen Frequenzen, insbesondere größer 1 kHz, erlaubt eine gute Abschätzung der Temperatur. Anhand möglichst niedriger Frequenzen kann das Diffusionsverhalten und somit können die DC-Widerstände Widerstände $R_{ch}$ und $R_{dch}$ abgeschätzt werden. Dadurch erübrigt sich die vorgelagerte Erstellung einer Look-up-Table und spart daher viel Zeit.

Bei der überlagerten Impedanzmessung müssen insbesondere mehrere Aspekte berücksichtigt werden. Für eine solide Messung muss sich das Messobjekt wie ein LZI-System verhalten, insbesondere linear und zeitinvariabel. Wird eine Messperiode zu lang, gilt die Zeitinvarianz nicht mehr, da sich der Ladezustand und die Spannungen messbar ändern. In Abhängigkeit von dem Lade-/Entladestrom, also dem Stromwert $I_{HPC}$, muss die maximale Periodendauer, dementsprechend die minimale Anregungsfrequenz evaluiert werden. Eine gängige Beurteilung zur Beurteilung der Validität einer EIS ist der Kramers-Kronig-Test.

Ferner muss sichergestellt werden, dass die periodische Anregung der EIS ladungsneutral ist, damit sie die HPC nicht verfälscht. Um mögliche Fehlereinflüsse zu minimieren, wird die EIS in einem möglichst kleinen Zeitfenster, insbesondere dem Zeitfenster 22, durchgeführt. Das Zeitfenster sollte dabei möglichst am Ende eines Zyklus liegen, damit die anliegende Überspannung $\eta_{ch}$, $\eta_{dch}$ möglichst nahe am Ende des Ladezustands bestimmt werden kann. Das Zeitfenster darf jedoch auch nicht bis zum Ende des Zyklus reichen, um ausschließen zu können, dass über den avisierten Ladezustand hinaus geladen wird, weil die EIS-Messung abgeschlossen werden muss.

Falls die Ladungsneutralität nicht vollständig gewährleistet werden kann, könnte ebenfalls vorab eine EIS-Messung ohne Strom-Offset durchgeführt werden und die Be- oder Entladungsmenge bestimmt werden. Dieser Wert kann als Korrekturfaktor berücksichtigt werden.

Bezugszeichenliste

| | |
|---|---|
| 10 | Messvorrichtung |
| 12 | Zyklisierer |
| 14 | elektronische Recheneinrichtung 14 |
| 16 | Batteriezelle |

| 18 | erste Kurve |
| 20 | zweite Kurve |
| 22 | Zeitfenster |
| lhpc | vorgegebener Stromwert |
| $I_W$ | Wechselstrom |
| Uw | Spannung |
| t | Zeit |
| V | Spannung |
| $V_{max}$ | maximale Ladespannung |
| $V_{min}$ | minimale Ladespannung |
| $OCV_{max}$ | maximale Leerlaufspannung |
| $OCV_{min}$ | maximale Ladespannung |
| $\eta_{ch}$ | erste Überspannung |
| $\eta_{dch}$ | zweite Überspannung |

**Patentansprüche**

1. Verfahren zum Bestimmen zumindest einer ersten Überspannung ($\eta_{ch}$) zwischen einer maximalen Leerlaufspannung ($OCV_{max}$) einer Batteriezelle (16) und einer maximalen Ladespannung ($V_{max}$) der Batteriezelle (16) mittels einer Messvorrichtung (10), mit den Schritten:

   - Laden der Batteriezelle (16) mit einem vorgegebenen Stromwert ($I_{HPC}$) von einer minimalen Ladespannung ($V_{min}$) zu der maximalen Ladespannung ($V_{max}$) mittels eines Zyklisierers (12) der Messvorrichtung (10);
   - Überlagern des vorgegebenen Stromwerts ($I_{HPC}$) während des Ladens mit einem Wechselstrom ($I_W$) mittels des Zyklisierers (12);
   - Bestimmen einer die Batteriezelle (16) charakterisierenden Eigenschaft in Abhängigkeit von dem überlagerten Wechselstrom ($I_W$) mittels einer elektronischen Recheneinrichtung (14) der Messvorrichtung (10);
   - Bestimmen der ersten Überspannung ($\eta_{ch}$) in Abhängigkeit von der bestimmten charakterisierenden Eigenschaft mittels der elektronischen Recheneinrichtung (14).

2. Verfahren nach Anspruch 1, **dadurch gekennzeichnet, dass** als charakterisierende Eigenschaft eine Temperatur in der Batteriezelle (16) bestimmt wird.

3. Verfahren nach Anspruch 2, **dadurch gekennzeichnet, dass** der Stromwert ($I_{HPC}$) mit einem Wechselstrom (Iw) mit einer Frequenz von mehr als 1kHz überlagert wird.

4. Verfahren nach einem der vorhergehenden Ansprüche, **dadurch gekennzeichnet, dass** als charakterisierende Eigenschaft ein Gleichstromwiderstand in der Batteriezelle (16) bestimmt wird.

5. Verfahren nach Anspruch 4, **dadurch gekennzeichnet, dass** der Stromwert ($I_{HPC}$) mit einem Wechselstrom (Iw) mit einer Frequenz von weniger als 1kHz überlagert wird.

6. Verfahren nach einem der vorhergehenden Ansprüche, **dadurch gekennzeichnet, dass** mittels des überlagerten Wechselstroms ($I_W$) eine Impedanzanalyse der Batteriezelle (16) durchgeführt wird.

7. Verfahren nach einem der vorhergehenden Ansprüche, **dadurch gekennzeichnet, dass** mittels des überlagerten Wechselstroms ($I_W$) eine zweite Überspannung ($\eta_{dch}$) der Batteriezelle (16) zwischen einer minimalen Leerlaufspannung ($OCV_{min}$) und einer minimalen Ladespannung ($V_{min}$) durchgeführt wird.

8. Verfahren nach einem der vorhergehenden Ansprüche, **dadurch gekennzeichnet, dass** die Überlagerung des Wechselstroms (Iw) im Wesentlichen an einem Ende des Ladevorgangs durchgeführt wird.

9. Verfahren nach Anspruch 8, **dadurch gekennzeichnet, dass** die Überlagerung des Wechselstroms (Iw) vor einem Ende des Ladevorgangs abgeschlossen wird.

10. Verfahren nach einem der vorhergehenden Ansprüche, **dadurch gekennzeichnet, dass** zumindest ein erster Wechselstrom (Iw) mit einer ersten Frequenz und ein zweiter Wechselstrom ($I_W$) mit einer zur ersten Frequenz unterschiedlichen zweiten Frequenz auf den Stromwert ($I_{HPC}$) überlagert werden.

11. Verfahren nach einem der vorhergehenden Ansprüche, **dadurch gekennzeichnet, dass** eine zugeführten Ladungsmenge während des Ladens bestimmt wird und die Batteriezelle (16) mit dem vorgegebenen Stromwert ($I_{HPC}$) von der maximalen Ladespannung ($V_{max}$) zu einer minimalen Entladespannung ($V_{min}$) mittels des Zyklisierers (12) entladen wird und eine entnommene Ladungsmenge während des Entladens bestimmt wird und ein Alterungszustand der Batteriezelle (16) und/oder eine Selbstentladung der Batteriezelle (16) in Abhängigkeit von der bestimmten zugeführten Ladungsmenge und der bestimmten entnommenen Ladungsmenge bestimmt wird.

12. Verfahren nach einem der vorhergehenden Ansprüche, **dadurch gekennzeichnet, dass** das Verfahren während eines Hochpräzisionscoulometrie-Verfahrens durchgeführt wird.

13. Computerprogrammprodukt mit Programmcodemitteln, welche eine elektronische Recheneinrichtung (14) dazu veranlassen, wenn die Programmcodemittel von der elektronischen Recheneinrichtung (14) abgearbeitet werden, ein Verfahren nach einem der Ansprüche 1 bis 12 durchzuführen.

14. Computerlesbares Speichermedium mit einem Computerprogrammprodukt nach Anspruch 13.

15. Messvorrichtung (10) zum Bestimmen zumindest einer ersten Überspannung ($\eta_{ch}$) zwischen einer maximalen Leerlaufspannung ($OCV_{max}$) einer Batteriezelle (16) und einer maximalen Ladespannung ($V_{max}$) der Batteriezelle (16), mit zumindest einem Zyklisierer (12) und einer elektronischen Recheneinrichtung (14), wobei die Messvorrichtung (10) zum Durchführen eines Verfahrens nach einem der Ansprüche 1 bis 12 ausgebildet ist.

FIG 1

FIG 2

FIG 3

EP 4 624 951 A1

Europäisches
Patentamt

European
Patent Office

Office européen
des brevets

# EUROPÄISCHER RECHERCHENBERICHT

**Nummer der Anmeldung**

EP 24 16 6893

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | EP 4 148 443 B1 (SAMSUNG ELECTRONICS CO LTD [KR]) 20. März 2024 (2024-03-20) <br> * Abbildung 2 * <br> * Absätze [0006], [0007], [0042], [0056], [0070], [0088], [0089] * <br> - - - - - | 1-9, 11-15 | INV. <br> G01R31/36 <br> G01R31/389 <br> H02J7/00 |
| Y <br><br> A | EP 4 099 039 B1 (TOSHIBA KK [JP]) 20. September 2023 (2023-09-20) <br> * Absatz [0003] * <br> - - - - - | 1-9, 11-15 <br><br> 10 | |
| A | DE 10 2019 211913 A1 (VOLKSWAGEN AG [DE]) 14. Mai 2020 (2020-05-14) <br> * Absatz [0009] - Absatz [0011] * <br> * Absätze [0029], [0058] * <br> - - - - - | 1-15 | |
| A | DE 11 2016 000834 T5 (MITSUBISHI ELECTRIC CORP [JP]) 30. November 2017 (2017-11-30) <br> * Absatz [0072] - Absatz [0075] * <br> - - - - - | 1-15 | |

**RECHERCHIERTE SACHGEBIETE (IPC)**

G01R
H02J

Der vorliegende Recherchenbericht wurde für alle Patentansprüche erstellt

| Recherchenort | Abschlußdatum der Recherche | Prüfer |
|---|---|---|
| Den Haag | 16. Oktober 2024 | Nierhaus, Thomas |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 24 16 6893

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

16-10-2024

| Im Recherchenbericht angeführtes Patentdokument | Datum der Veröffentlichung | Mitglied(er) der Patentfamilie | Datum der Veröffentlichung |
|---|---|---|---|
| EP 4148443 B1 | 20-03-2024 | CN 115774212 A | 10-03-2023 |
|  |  | EP 4148443 A1 | 15-03-2023 |
|  |  | KR 20230036707 A | 15-03-2023 |
|  |  | US 2023073869 A1 | 09-03-2023 |
| EP 4099039 B1 | 20-09-2023 | CN 115436830 A | 06-12-2022 |
|  |  | EP 4099039 A1 | 07-12-2022 |
|  |  | JP 7395540 B2 | 11-12-2023 |
|  |  | JP 2022184419 A | 13-12-2022 |
|  |  | US 2022381845 A1 | 01-12-2022 |
| DE 102019211913 A1 | 14-05-2020 | CN 111175664 A | 19-05-2020 |
|  |  | DE 102019211913 A1 | 14-05-2020 |
| DE 112016000834 T5 | 30-11-2017 | CN 107250825 A | 13-10-2017 |
|  |  | DE 112016000834 T5 | 30-11-2017 |
|  |  | JP 6055960 B1 | 27-12-2016 |
|  |  | JP 6403746 B2 | 10-10-2018 |
|  |  | JP 2017067788 A | 06-04-2017 |
|  |  | JP WO2016132813 A1 | 27-04-2017 |
|  |  | US 2018017628 A1 | 18-01-2018 |
|  |  | WO 2016132813 A1 | 25-08-2016 |

EPO FORM P0461

Für nähere Einzelheiten zu diesem Anhang : siehe Amtsblatt des Europäischen Patentamts, Nr.12/82